# EUROPÄISCHE PATENTANMELDUNG

(11) **EP 0 651 444 A2**
(43) Veröffentlichungstag der Anmeldung: **03.05.1995**
(21) Anmeldenummer: 94116765.2
(22) Anmeldetag: 25.10.1994
(51) Int. Cl.: H01L 27/146

(54) **Photodetektorarray**

(30) Priorität: 30.10.1993 DE 4337160
(71) Anmelder: Daimler-Benz Aerospace Aktiengesellschaft, D-81663 München (DE)
(72) Erfinder: Platz, Willi, Dr., D-81739 München (DE); Riedel, Helmut, D-82256 Fürstenfeldbruck (DE); Königer, Max, Dr., D-81479 München (DE)

(57) **Zusammenfassung**

Dieses Photodetektorarray weist eine Vielzahl in einer Fläche regelmäßig angeordneter Photodetektorelemente 16, 10, 13 mit jeweils einer zugehörigen Ausgangsleitung 18 und daran angeschlossenem Differenzbildner 20 auf. Um einen möglichst hohen Füllfaktor zu erzielen, sind mindestens zwei Schichten A und B vorgesehen, wobei die Photodetektorelemente in der ersten, dem Lichteinfall zugekehrten Schicht A angeordnet und untereinander direkt über Strecken steuerbarer elektrischer Leitfähigkeit 26, 23, beispielsweise Kanäle von MOS-Transistoren, verbunden sind. Die Gate-Elektroden 28 der MOS-Transistoren sind mit einem Netz 2 von zwischen den Photodetektorelementen verlaufenden Steuerleitungen verbunden. Alle übrigen Schaltungselemente, insbesondere die Differenzbildner 20 sowie noch erforderliche Speicherelemente 19 sind in der zweiten, koplanar zur ersten angeordneten Schicht B untergebracht.

## Beschreibung

Die Erfindung betrifft ein Photodetektorarray gemäß dem Oberbegriff des Patentanspruchs 1.

Ein derartiges Photodetektorarray ist aus "Analog VLSI and Neural Systems" von Carver Mead, 1989, bekannt. Dort wird in Chapter 15 auf den Seiten 257 bis 278, insbesondere Seiten 262 bis 264 und Fig. 15.5, in Verbindung mit den Seiten 118 und 119 ein Photodetektorarray beschrieben, das als intergierte Schaltung in einer Ebene ausgeführt ist. Eine Vielzahl von Photodetektorelementen ist dabei in einer Fläche regelmäßig, und zwar in hexagonaler Strukturierung, angeordnet. In den relativ großflächigen Lücken zwischen den Photodetektorelementen befinden sich weitere Schaltungselemente, die zum Betrieb des Phototdetektorarrays erforderlich sind. Zunächst besitzt jedes Phototdetektorelement eine Ausgangsleitung, die einmal an einen Differenzbildner in Form eines Differenzverstärkers und zum anderen an eine Strecke steuerbarer elektrischer Leitfähigkeit in Form eines Steilheits-Verstärkers (Transconductance Amplifier, s. U. Tietze, C. Schenk, "Halbleiter-Schaltungstechnik", 1986, S. 730) angeschlossen ist. Der Ausgang dieses Steilheits-Verstärkers ist auf den Eingang rückgekoppelt und gleichzeitig mit einem zweiten Eingang des Differenzverstärkers verbunden. In der Ebene der Photodetektorelemente ist gleichzeitig ein Widerstandsnetzwerk realisiert, welches ebenfalls eine hexagonale Struktur aufweist. Der Ausgang eines jeden Steilheits-Verstärkers ist zu einem zugeordneten Knotenpunkt dieses Widerstandsnetzwerkes geführt, welcher wiederum über sechs angeschlossene, steuerbare Widerstände bzw. Strecken steuerbarer elektrischer Leitfähigkeit mit sechs weiteren, den sechs jeweils benachbarten Photodetektorelementen zugeordneten Knotenpunkten des Widerstandsnetzwerkes verbunden ist. Diese steuerbaren Widerstände sind beispielsweise als Kanalstrecken von MOS-Transistoren ausgeführt, wobei die Gates dieser je sechs einem Knotenpunkt zugeordneten Transistoren über einen gemeinsamen Steuerkreis ansteuerbar sind. Die Ausgangsspannung des Steilheits-Verstärkers liegt einerseits am zugeordneten Knotenpunkt an und beeinflußt andererseits den Steuerkreis.

Dieses bekannte Photodetektorarray ist speziell zu dem Zweck entworfen, die Photorezeptoren der Augennetzhaut sowie deren Funktion nachzubilden. Wie beispielsweise in "Spektrum der Wissenschaft", Februar 1987, Seiten 66 bis 75, beschrieben ist, besteht ein wesentliches Charakteristikum der Funktionsweise der Augennetzhaut darin, daß gewissen Zelltypen sogenannte rezeptive Felder zugeordnet sind. Bei Lichteinfall reagieren die in der Umgebung des Feldzentrums gelegenen Zellen in genau entgegengesetzter Weise wie die im Feldzentrum gelegene Zelle. Die Reaktionsweise einer Zelle ist also nicht unabhängig von der Umgebung. Um dieser Funktionsweise Rechnung zu tragen, ist bei dem bekannten Photodetektorarray das erwähnte Widerstandsnetzwerk vorgesehen, dessen Knotenpunkte den einzelnen Photodetektorelementen jeweils in der geschilderten Weise zugeordnet sind. Durch entsprechende Beeinflussung der Strecken steuerbarer elektrischer Leitfähigkeit, d.h. des Leitwertes der jeweiligen Steilheits-Verstärker und/oder der Kanalstrecken der die steuerbaren Widerstände bildenden Transistoren, kann erreicht werden, daß die Ausgangspotentiale der einzelnen Photodetektorelemente mehr oder weniger weit auf deren Umgebung einwirken.

Das bekannte Photodetektorarray weist aber erhebliche Nachteile auf. So ist der Füllfaktor bezüglich des durch die photoempfindlichen Flächen der Photodetektorelemente ausgenutzten Flächenanteils sehr gering, da ein erheblicher Teil der Sensoroberfläche durch die bereits beschriebenen sowie weitere Schaltungselemente in Anspruch genommen wird. Außerdem ist der schaltungstechnische und der folglich bei der Herstellung zu treibende verfahrenstechnische Aufwand sehr hoch, da ein Widerstandsnetzwerk mit einer der Anzahl der Knotenpunkte bzw. Photodetektorelemente entsprechenden Zahl von Steuerkreisen vorhanden sein muß.

Der Erfindung liegt daher die Aufgabe zugrunde, ein Photodetektorarray der eingangs genannten Art bereitzustellen, welches einen möglichst hohen Füllfaktor aufweist und sich durch einen möglichst geringen schaltungstechnischen Aufwand auszeichnet.

Diese Aufgabe ist gemäß der Erfindung durch die im kennzeichnenden Teil des Patentanspruchs 1 genannten Merkmale gelöst.

Demnach weist das Photodetektorarray nunmehr im Gegensatz zu dem oben beschriebenen einen mindestens zweischichtigen Aufbau derart auf, daß die Photodetektorelemente in einer ersten, dem Lichteinfall zuzukehrenden Schicht angeordnet sind und die Differenzbildner mit jeweils mindestens einem zugeordneten Speicherelement sich in einer zweiten, koplanar zur ersten angeordneten Schicht befinden. Äußerst wichtig für die nach wie vor erhaltene Funktionsweise im Sinne eines rezeptiven Feldes ist, daß die lichtempfindlichen Bereiche benachbarter Photodetektorelemente nunmehr direkt über die Strecken steuerbarer elektrischer Leitfähigkeit miteinander verbunden sind. Hierdurch erübrigt sich die aufwendige Realisierung eines Widerstandsnetzwerks mit der hohen Anzahl zugeordneter Steuerkreise. In der ersten Schicht befinden sich lediglich noch die Photodetektorelemente selbst sowie die zwischen diesen jeweils vorgesehenen Strecken steuerbarer elektrischer Leitfähigkeit. Durch Variierung dieser Leitfähigkeit kann erreicht werden, daß die bei Lichteinfall in den photoempfindlichen Bereichen der Photodetektorelemente generierten Ladungen in mehr oder weniger großem Ausmaß zu den benachbarten Photodetektorelementen hinüberfließen. Hierdurch kann die Ausdehnung des jeweiligen rezeptiven Feldes beeinflußt werden. Da sämtliche anderen Schaltungselemente, beispielsweise die Differenzbildner, die zugeordneten Speicherelemente sowie die Schaltungselemente zur Signalauslese und -verarbeitung sich nicht mehr in der ersten Schicht befinden, sondern in die zweite oder eine weitere verlagert sind, können die Photodetektorelemente in der ersten Schicht sehr dicht aneinandergerückt werden, wobei lediglich darauf zu achten ist, daß die photoempfindlichen Bereiche gegeneinander isoliert werden können. Dem zur Bildung rezeptiver Felder erforderlichen Ladungstransport dienen lediglich die Strecken steuerbarer elektrischer Leitfähigkeit zwischen jeweils benachbarten Photodetektorelementen, welche jedoch so ausgebildet werden können, daß sie nur einen geringen Flächenbedarf aufweisen, wodurch ein hoher Füllfaktor ermöglicht wird.

Insgesamt zeichnet sich das erfindungsgemäße Photodetektorarray durch einen hohen Füllfaktor hinsichtlich der Flächennutzung durch die eigentlichen Photodetektorelemente aus, wobei die Funktion des rezeptiven Feldes auf sehr direkte Weise unter weitestgehender Vermeidung überflüssigen Schaltungsaufwandes realisiert ist.

In den Unteransprüchen sind vorteilhafte Ausbildungen des erfindungsgemäßen Photodetektorarrays sowie Verfahren zu dessen Betrieb angegeben.

Die Strecken steuerbarer elektrischer Leitfähigkeit können als Kanäle von MOS-Transistoren ausgeführt sein. Die zugehörigen Gate-Elektroden können noch in der ersten Schicht unter diesen Kanälen angeordnet sowie durch ein zwischen den Photodetektorelementen verlaufendes Netz von Steuerleitungen miteinander verbunden sein.

Das Photodetektorarray kann derart strukturiert sein, daß die Steuer- bzw. Gate-Elektroden jeweils einzeln oder in auswählbaren Gruppen ansteuerbar sind. Damit kann erreicht werden, daß die rezeptiven Felder über die Oberfläche des Photodetektorarrays hin je nach Bedarf unterschiedliche Ausdehnung haben.

Als besonders günstig hinsichtlich der Flächennutzung und der Organisation von rezeptiven Feldern bietet sich eine hexagonale Anordnung der Photodetektorelemente an.

Ein zweischichtiger Aufbau des Photodetektorarrays kann derart realisiert sein, daß zunächst zwei separate, jeweils eine der Schichten bildende Platten vorhanden sind, deren eine die Photodetektorelemente sowie die zugehörigen Strecken steuerbarer elektrischer Leitfähigkeit, beispielsweise in Form von MOS-Transistoren, und die erforderlichen Steuerelektroden sowie -leitungen enthält, und deren andere mit sämtlichen übrigen erforderlichen Schaltungselementen und Leitungen versehen ist. Diese beiden Platten können dann an den Positionen der einzelnen Photodetektorelemente über elektrische Kontakte miteinander verbunden sein.

Soll die Funktion der Simulation eines rezeptiven Feldes verwirklicht werden, so wird folgendermaßen vorgegangen: Während aufeinanderfolgender Zeitintervalle kommen alternierend zwei unterschiedliche Betriebsarten zum Einsatz. In der einen Betriebsart werden die Strecken steuerbarer elektrischer Leitfähigkeit so angesteuert, daß sie leitend sind, und in der anderen so, daß sie nicht leitend sind. Dies hat zur Folge, daß in der einen Betriebsart die sich während eines Zeitintervalls bei Lichteinfall ansammelnden Ladungen in die benachbarten Photodetektorelemente hinüberfließen können, und zwar in einem Ausmaß, welches von der jeweils durch die Ansteuerung eingestellten Leitfähigkeit der die Photodetektorelemente verbindenden Strecken abhängt. Durch entsprechende Wahl des Potentials der Steuerelektroden kann diese Leitfähigkeit gezielt beeinflußt werden. In der anderen Betriebsart, in der die Leitfähigkeit der Strecken auf nahezu Null herabgesetzt ist, sind die einzelnen Photodetektorelemente völlig voneinander isoliert. Beim Auslesen entsteht daher ein scharfes Bild, während in der zuerst genannten Betriebsart wegen des zumindest teilweisen Hinüberfließens der Ladungen in die benachbarten Photodetektorelemente nach dem Auslesen ein verwischtes, mehr oder weniger unscharfes Bild entsteht.

Bei der Auswertung werden nun je zwei aufeinanderfolgende Zeitintervalle zu einem Bildtakt zusammengefaßt. Dabei werden die am Ende jedes der beiden Zeitintervalle eines Bildtaktes anstehenden Ausgangssignale jedes einzelnen Photodetektorelementes in dem jeweils zugeordneten Differenzbildner voneinander subtrahiert, wobei das zuerst anfallende Ausgangssignal während des zweiten der beiden Zeitintervalle zwischengespeichert werden muß, und zwar in einem eigens dafür vorgesehenen Speicherelement.

Im Gegensatz zu dem eingangs beschriebenen Photodetektorarray wird das rezeptive Feld hier nicht dadurch realisiert, daß kontinuierlich die Differenzen zwischen Einzel-Photodetektorelement und Umfeld gebildet werden, sondern durch Differenzbildung zwischen zwei aufeinanderfolgenden Zeitintervallen innerhalb eines Bildtaktes.

Im folgenden ist die Erfindung in einem Ausführungbeispiel anhand der Abbildungen näher erläutert. Es zeigen in schematischer Weise:
Fig. 1 eine Draufsicht auf ein Photodetektorarray gemäß der Erfindung,
Fig. 2 einen ersten Querschnitt durch das Photodetektorarray gemäß der Fig. 1,
Fig. 3 einen zweiten Querschnitt durch das Photodetektorarray der Fig,
Fig. 4 Diagramme zur Darstellung der Signalauswertung.

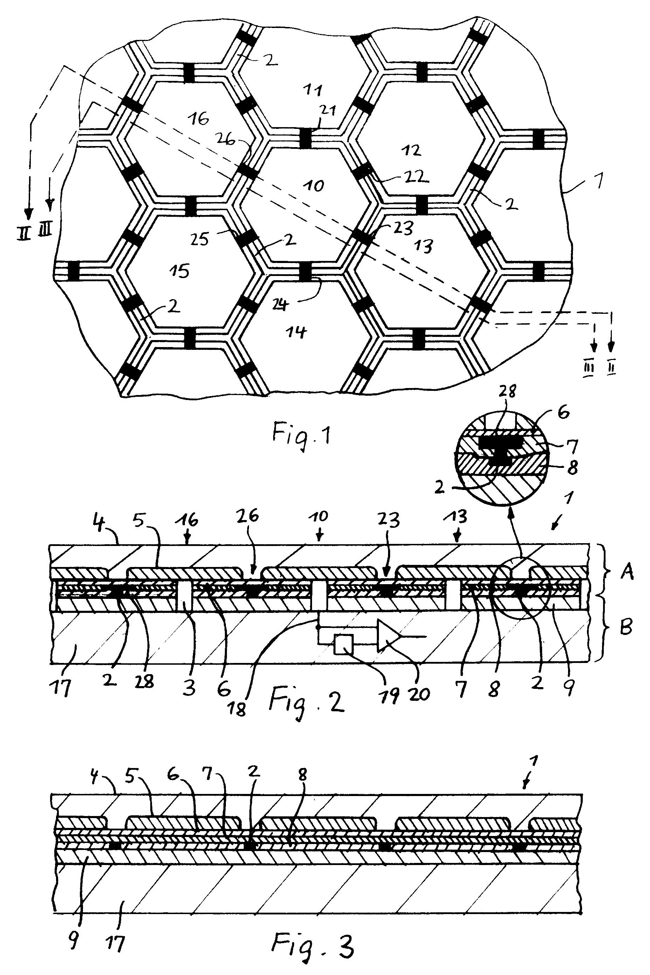

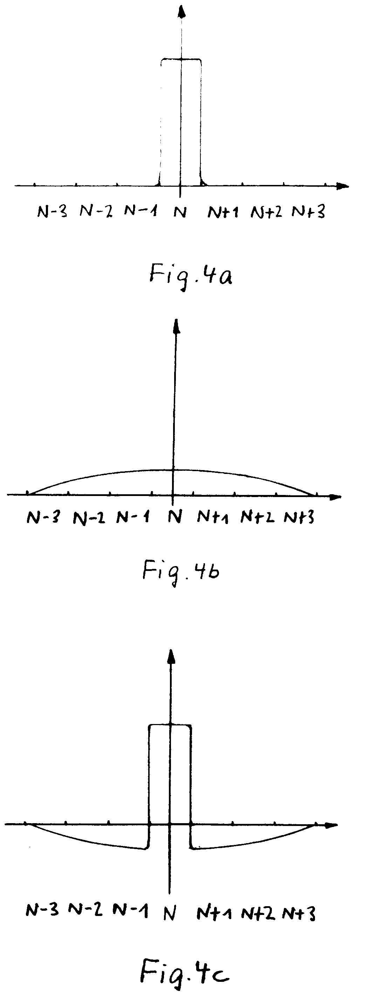

Fig. 1 zeigt in Draufsicht einen Ausschnitt eines Photodetektorarrays 1. Es handelt sich um eine schematische Darstellung, welche die Struktur verdeutlichen soll, wobei die genaue Anordnung der einzelnen Elemente in der Tiefe aus den Fig. 2 und 3 hervorgeht, die Querschnitte des Photodetektorarrays gemäß Fig. 1 darstellen. Der Querschnitt gemäß Fig. 2 ist entlang der gestrichelten Linie II und der Querschnitt gemäß Fig. 3 entlang der gestrichelten Linie III in Fig. 1 geführt.

Gemäß Fig. 1 sind Photodetektorelemente 10 bis 16 usw. in hexagonaler Struktur in einer Ebene angeordnet. Die photoempfindlichen Bereiche dieser Photodetektorelemente sind durch Strecken steuerbarer elektrischer Leitfähigkeit 21 bis 26 miteinander verbunden. Diese Strecken werden durch ein Netz 2 von Steuerleitungen je nach deren Potential so beeinflußt, daß sie mehr oder weniger gut leitend sind. Insbesondere ist es auch möglich, die Strecken vollständig zu sperren.

Fig. 2 zeigt den integrierten Aufbau des Photodetektorarrays 1 in einem durch die Mitten der Photodetektorelemente 16, 10 und 13 führenden Querschnitt. Es liegt ein zweischichtiger Aufbau vor, wobei die beiden Schichten A und B jeweils aus Unterschichten aufgebaut sind. Die beiden Schichten A und B können separat hergestellt sein und später durch ohmsche Kontakte 3 und ggf. durch (nicht dargestellte) flächenhafte Verklebung miteinander verbunden sein.

Die Schicht A trägt die Photodetektorelemente, beispielsweise 16, 10 und 13, und weist eine erste, beispielsweise aus p-leitendem Silizium mit eingelagerten n-leitenden Bereichen 5 bestehende Unterschicht 4 auf. Die dadurch entstehenden flächenhaften pn-Übergänge bestimmen die photoempfindlichen Bereiche der Photodetektorelemente 16, 10, 13 usw. Im Zentrum der Photodetektorelemente sind jeweils elektrisch leitfähige, insbesondere ohmsche Kontakte 3 vorgesehen, welche punktuelle elektrische Verbindungen zur zweiten Schicht B herstellen. Die Kontakte 3 durchdringen drei weitere Unterschichten der Schicht A, nämlich eine beispielsweise aus Siliziumdioxid oder Siliziumnitrid bestehende, elektrisch isolierende Schicht 6 sowie zwei Passivierungsschichten 7 und 8. In die erste Passivierungsschicht 7 sind Elektroden 28, beispielsweise aus Polysilizium, und in die zweite Passivierungsschicht 8 ist das mit den Elektroden 28 in elektrischem Kontakt stehende Netz 2 von Steuerleitungen eingelassen. In Fig. 2 oberhalb der Elektroden 28 ist die Struktur eines MOS-Transistors vorgegeben, wobei durch Beeinflussung des Potentials der Elektroden 28 mittels der Steuerleitungen erreicht werden kann, daß oberhalb der Elektroden 28 und zwischen den Photodetektorelementen, beispielsweise 16, 10 und 13, Strecken steuerbarer elektrischer Leitfähigkeit, beispielsweise 26 und 23, existieren. Je nach der Dotierungsstruktur der ersten Unterschicht 4 kann durch Anlegen eines entsprechenden Potentials an die Elektroden 28, die die Funktion von Gate-Elektroden haben, die Leitfähigkeit der Strecken 26, 23 usw. auf Null bzw. auf einen gewünschten höheren Wert eingestellt werden. Es kann also eine erste Betriebsart angewählt werden, in der die Strecken 23, 26 usw. leitend sind, und eine zweite Betriebsart, in der diese Strecken nicht leitend bzw. gesperrt sind.

Die herausgeführte Detailstruktur zu Fig. 2 zeigt eine etwas mehr der praktischen Ausführung angenäherte Darstellung. In die zunächst die Elektroden 28 bedeckende Passivierungsschicht 7 werden im Zuge des Herstellungsverfahrens Löcher eingebracht, welche die Oberfläche der Elektroden 28 teilweise bloßlegen. Beim anschließenden Aufbringen des Netzes 2 von Steuerleitungen dringt leitendes Material in diese Löcher ein und stellt den Kontakt zu den Elektroden 28 her.

Im Falle der vorliegenden Ausführungsform sind die Steuerleitungen als zusammenhängendes Netz 2 ausgebildet, so daß die Potentialverhältnisse der Elektroden 28 insgesamt in gleicher Weise beeinflußt werden. Es ist jedoch auch möglich, ein System von Steuerleitungen derart zu entwerfen, daß einzelne Photodetektorelemente bzw. Gruppen von Photodetektorelementen gesondert ansteuerbar sind. In dem einfachen dargestellten Beispiel befindet sich das gesamte Netz 2 von Steuerleitungen in der Schicht A, und auch die äußeren Kontakte zur Potentialzuführung können an diese Schicht angeschlossen sein. Es ist aber auch möglich, insbesondere im Fall einer gruppenweisen Ansteuerung der Photodetektorelemente, Teile der Steuerleitungssysteme in die Schicht B zu verlegen, wobei für eine geeignete Kontaktierung bei der Zusammenfügung der beiden Schichten A und B gesorgt werden muß.

Durch die dargestellte Ausbildung der Schicht A ist sichergestellt, daß insgesamt ein hoher Füllfaktor hinsichtlich der Flächennutzung und damit eine hohe Lichtstärke gegeben sind. Die Möglichkeit, Ladungen von einem Potodetektorelement in die benachbarten hinüberfließen zu lassen, ist auf sehr einfache und platzsparende Weise realisiert, so daß die Einsatzfähigkeit des Photodetektorarrays für die Simulierung rezeptiver Felder gewährleistet ist.

Die zweite Schicht B besteht aus einer Unterschicht 17, beispielsweise ebenfalls aus Silizium, sowie einer Passivierungsschicht 9, welche ebenso wie die beiden Passivierungsschichten 7 und 8 der ersten Schicht A aus Siliziumdioxid oder Siliziumnitrid bestehen kann. Die Kontakte 3 sind jeweils an Ausgangsleitungen 18 angeschlossen, die wiederum einerseits direkt dem einen Eingang eines Differenzbildners 20, beispielsweise eines Differenzverstärkers, und andererseits über ein Speicherelement 19 dessen anderem Eingang zugeführt sind, wie lediglich schematisch dargestellt.

Fig. 3 zeigt einen weiteren, längs der gestrichelten Linie III in Fig. 1 außerhalb der Mitten der Photodetektorelemente 16, 10 sowie 13 geführten Querschnitt. Dieser Schnitt führt nicht mehr durch die Kontakte 3 sowie die Elektroden 28 (Gate-Elektroden), jedoch noch durch das Netz 2 von Steuerelektroden. Die übrigen Bezugszeichen entsprechen denen der Fig. 2.

In den Fig. 4a bis 4c wird die Funktion des erfindungsgemäßen Photodetektorarrays beschrieben, wenn in zwei aufeinanderfolgenden Zeitintervallen die beiden erwähnten unterschiedlichen Betriebsarten zum Einsatz kommen und anschließend beide Zeitintervalle zu einem Bildtakt zusammengefaßt werden. Auf der Abzisse sind schematisch jeweils mehrere zu beiden Seiten eines zentralen Photodetektorelementes N anschließende weitere Photodetektorelemente N ±1, N ±2 usw. dargestellt. Auf der Ordinate ist der bei Lichteinfall durch Ladungsgenerierung entstehende Signalpegel aufgetragen.

In Fig. 4a ist die "scharfe" Betriebsart wiedergegeben, wobei vorausgesetzt ist, daß ein Lichtfleck nur das zentrale Photodetektorelement N trifft. In dieser Betriebsart sind die zwischen den Photodetektorelementen angeordneten Strecken steuerbarer elektrischer Leitfähigkeit gesperrt. Die generierte Ladungsmenge verbleibt also im zentralen Photodetektorelement N. Fig. 4b zeigt demgegenüber die "unscharfe" Betriebsart, bei der die (hier nicht dargestellten) zwischen den einzelnen Photodetektorelementen liegenden Strecken steuerbarer elektrischer Leitfähigkeit "geöffnet" sind. Dies führt dazu, daß die im zentralen Photodetektorelement N generierten Ladungen teilweise in die benachbarten Photodetektorelemente hinüberfließen können. Dieser Effekt wird mit zunehmender Entfernung vom zentralen Photodetektorelement N immer weiter abgeschwächt, hängt aber außerdem von der Länge des Zeitintervalls ab.

Fig. 4c zeigt schließlich das Ergebnis der Subtraktion der in den beiden aufeinanderfolgenden Zeitintervallen eines Bildtaktes gebildeten unterschiedlichen Signalanteile in den jeweiligen Differenzbildnern nach Zwischenspeicherung der jeweils zuerst gebildeten Signalanteile in den jeweiligen Speicherelementen. Es ist deutlich zu erkennen, daß durch die Subtraktion das Ausgangssignal des dem zentralen Photodetektorelement N zugeordneten Differenzbildners zwar etwas abgeschwächt ist, dafür jedoch in den nächst benachbarten Photodetektorelementen N ±1 usw. nunmehr Signalanteile kleinerer Amplitude und umgekehrten Vorzeichens auftreten, obwohl der Lichtfleck diese benachbarten Photodetektorelemente nicht getroffen hat. Dies entspricht der Funktionsweise der rezeptiven Felder gewisser Zellen der Augennetzhaut.

Anstelle der oben erwähnten einzelnen MOS-Transistoren können auch komplexere Transistorschaltungen realisiert werden, um beispielsweise nichtlineare Kennlinien, etwa mit sättigendem Strom-Spannungs-Verhalten, zu erzielen.

Das Ausmaß des "Verfließens" von Ladungsmengen aus einem Photodetektorelement in die benachbarten hängt davon ab, wie stark die durch die Strecken steuerbarer elektrischer Leitfähigkeit gebildeten Kanäle geöffnet werden. Geschieht dies nur in geringfügiger Weise, so gelangen die abfließenden Ladungen nur in eine begrenzte Umgebung des ladungsabgebenden zentralen Photodetektorelementes, wie beispielsweise in Fig. 4b dargestellt. Die Leitfähigkeit der genannten Kanäle kann aber auch so weit erhöht werden, daß die in einem zentralen Photodetektorelement generierten Ladungen sich auf die Photodetektorelemente des gesamten Arrays ausbreiten. Hierzu ist zu bemerken, daß dies in wenigen Nanosekunden geschehen kann, während die zur Ladungsgenerierung üblicherweise gewählten Zeitintervalle in der Größenordnung von Millisekunden liegen.

Ein sehr interessantes Anwendungsgebiet für das erfindungsgemäße Photodetektorarray liegt auf dem Gebiet der Infrarot-Bildaufnahmetechnik. Hier besteht oft das Problem, daß das eigentliche Bildsignal gegenüber der starken infraroten Hintergrundstrahlung nur geringe Intensität besitzt. Werden nun innerhalb eines Bildtaktes die beiden oben geschilderten Betriebsarten jeweils nacheinander zum Einsatz gebracht, so hat dies zur Folge, daß bei der anschließenden Differenzbildung die Hintergrundstrahlung vollständig kompensiert wird, d.h. im Ausgangssignal eines Bildtaktes nicht mehr auftritt. Hierbei ist zunächst vorausgesetzt, daß die Hintergrundstrahlung im gesamten erfaßten Bildausschnitt gleichmäßig ist, und daß die Kanäle zwischen den Photodetektorelementen so weit geöffnet sind, daß die Ladungen in der "unscharfen" Betriebsart vollständig über das gesamte Photodetektorarray verfließen können. Bei der Differenzbildung ist dann nurmehr das eigentliche Bildsignal vorhanden, und zwar mit einer Nullreferenz, welche dem Mittelwert dieses Bildsignales über das gesamte Array entspricht. Ist die Hintergrundstrahlung nicht über das gesamte Array gleichmäßig, so wird durch entsprechende Einstellung der Leitfähigkeit der genannten Kanäle dafür gesorgt, daß in der "unscharfen" Betriebsart nur noch ein lokaler Ladungsausgleich stattfinden kann, d.h. die Ladungen aus jedem Photodetektorelement nur noch in einen mehr oder weniger eng begrenzten Umgebungsbereich abfließen können. Damit ist es möglich, die lokal unterschiedliche Hintergrundstrahlung auch lokal angepaßt zu kompensieren.

Werden innerhalb eines Bildtaktes zwei Zeitintervalle der "scharfen" Betriebsart hintereinandergeschaltet, wird also vom Konzept des rezeptiven Feldes abgewichen, so ist das Photodetektorarray als Bewegungsdetektor einsetzbar. Bei der Differenzbildung zwischen den Ausgangssignalen der beiden Zeitintervalle verschwinden alle unverändert gebliebenen Bildelemente, und nur schnelle Änderungen bzw. Bewegungen liefern noch Information im Ausgangssignal der jeweiligen Differenzbildner.

## Patentansprüche

1. Photodetektorarray mit einer Vielzahl in einer Fläche regelmäßig angeordneter Photodetektorelemente mit jeweils einer zugehörigen Ausgangsleitung und daran angeschlossenem Differenzbildner sowie mit zwischen den Photodetektorelementen angeordneten Strecken steuerbarer elektrischer Leitfähigkeit, **dadurch gekennzeichnet,** daß das Photodetektorarray (1) einen mindestens zweischichtigen Aufbau aufweist, die Photodetektorelemente (10, 11, 12, 13, 14, 15, 16) in einer ersten, dem Lichteinfall zuzukehrenden Schicht (A) angeordnet sind, die lichtempfindlichen Bereiche benachbarter Photodetektorelemente direkt über die Strecken steuerbarer elektrischer Leitfähigkeit (21, 22, 23, 24, 25, 26) miteinander verbunden sind und die Differenzbildner (20) mit jeweils mindestens einem zugeordneten, ebenfalls an die jeweilige Ausgangsleitung (18) angeschlossenen Speicherelement (19) sich in einer zweiten, koplanar zur ersten angeordneten Schicht (B) befinden.

2. Photodetektorarray nach Anspruch 1, **dadurch gekennzeichnet,** daß Steuerelektroden (28) für die Strecken steuerbarer elektrischer Leitfähigkeit (21, 22,...) sowie daran angeschlossene Steuerleitungen (2) ebenfalls in der ersten Schicht (A) angeordnet sind.

3. Photodetektorarray nach Anspruch 1 oder 2, **dadurch gekennzeichnet;** daß die Strecken steuerbarer elektrischer Leitfähigkeit (21, 22,...) als Kanäle von MOS-Transistoren ausgeführt sind.

4. Photodetektorarray nach Anspruch 3, **dadurch gekennzeichnet,** daß die Gate-Elektroden (28) der MOS-Transistoren durch ein gemeinsames, zwischen den Photodetektorelementen (10, 11,...) verlaufendes Netz (2) von Steuerleitungen miteinander verbunden sind.

5. Photodetektorarray nach Anspruch 4, **dadurch gekennzeichnet,** daß die Gate-Elektroden der MOS-Transistoren einzeln oder in auswählbaren Gruppen ansteuerbar sind.

6. Photodetektorarray nach einem der vorhergehenden Ansprüche, **dadurch gekennzeichnet,** daß eine hexagonale Anordnung der Photodetektorelemente (10, 11,...) vorliegt.

7. Photodetektorarray nach einem der vorhergehenden Ansprüche, **dadurch gekennzeichnet,** daß ein zweischichtiger Aufbau durch zwei zunächst separate, jeweils eine der Schichten (A, B) bildende Platten realisiert ist, welche an den Positionen der einzelnen Photodetektorelemente (10, 11,...) über elektrisch leitfähige Kontakte (3) punktuell miteinander verbunden sind.

8. Verfahren zum Betreiben eines Photodetektorarrays gemäß einem der vorhergehenden Ansprüche, **dadurch gekennzeichnet,** daß während aufeinanderfolgender Zeitintervalle alternierend zwei unterschiedliche Betriebsarten zum Einsatz kommen und die Strecken steuerbarer elektrischer Leitfähigkeit jeweils so angesteuert werden, daß sie in der einen Betriebsart leitend und in der anderen Betriebsart nichtleitend sind.

9. Verfahren nach Anspruch 8, **dadurch gekennzeichnet,** daß je zwei aufeinanderfolgende Zeitintervalle zu einem Bildtakt zusammengefaßt werden.

10. Verfahren nach Anspruch 9, **dadurch gekennzeichnet,** daß die am Ende jedes der beiden Zeitintervalle eines Bildtaktes anstehenden Ausgangssignale jedes einzelnen Photodetektorelementes (10, 11,...) nach Zwischenspeicherung des zuerst anfallenden Ausgangssignals im Speicherelement (19) im Differenzbildner (20) voneinander subtrahiert werden.
